# FASCICULE DE BREVET EUROPEEN

(11) **EP 3 502 045 B1**
(45) Date de publication et mention de la délivrance du brevet: **14.10.2020**
(21) Numéro de dépôt: 18214893.2
(22) Date de dépôt: 20.12.2018
(51) Int. Cl.: B81C 1/00, G02B 6/42

(54) **PROCEDE D EXPOSITION D'UNE REGION SUR UNE FACE D'UN DISPOSITIF ELECTRONIQUE**
VERFAHREN ZUR EXPOSITION EINER REGION AUF EINER SEITE EINER ELEKTRONISCHEN VORRICHTUNG
METHOD FOR EXPOSING A REGION ON A SURFACE OF AN ELECTRONIC DEVICE

(30) Priorité: 21.12.2017 FR 1762887; 21.12.2017 FR 1762888
(43) Date de publication de la demande: 26.06.2019
(73) Titulaire: Commissariat à l'énergie atomique et aux énergies alternatives, 75015 Paris (FR)
(72) Inventeur: CHARBONNIER, Jean, 38000 GRENOBLE (FR); PORNIN, Jean-Louis, 38920 CROLLES (FR); CASTANY, Olivier, 38054 GRENOBLE (FR)
(74) Mandataire: Brevalex

(56) Documents cités:
- US-A1- 2013 266 262
- US-A1- 2014 203 380

## Description

### DOMAINE TECHNIQUE

La présente invention concerne un procédé d'exposition d'une région d'un dispositif électronique. En particulier, la présente invention concerne un procédé d'exposition d'une région, et dépourvue d'une gravure profonde.

La présente invention concerne également un procédé d'exposition pour la fabrication de structures de couplage et d'alignement permettant l'alignement et le couplage de fibres optiques sur un dispositif, par exemple un dispositif optoélectronique.

En particulier, les structures de couplage et d'alignement sont agencées pour permettre le couplage de la lumière d'au moins une fibre optique dans le dispositif optoélectronique. Notamment, les fibres optiques sont maintenues dans une ferrule qui présente des structures d'alignement destinées à coopérer avec des structures d'alignement complémentaires présentes sur le dispositif optoélectronique. Les structures fabriquées sur le dispositif optoélectronique comportent également des ouvertures servant de voie de passage pour la lumière. Dans un mode de réalisation particulier, la ferrule comporte également des optiques de mise en forme du faisceau, destinées à coopérer avec d'autres optiques de mise en forme du faisceau placées sur le dispositif optoélectronique dans les voies de passage de la lumière et associées aux éléments de couplage du dispositif optoélectronique.

### ART ANTÉRIEUR

Les étapes finales de fabrication des dispositifs électroniques peuvent impliquer le report d'une ou plusieurs structures électroniques 3 sur une face principale 4a d'une structure support 4 qui assure, par exemple, une cohésion mécanique de l'ensemble et/ou une connectivité électrique entre les différentes structures susceptibles d'être reportées sur ladite face.

Aussi, afin de protéger l'assemblage final des conditions environnementales auxquelles il se trouve exposé, le report des structures électroniques 3 est suivi d'une étape d'encapsulation qui comprend la formation d'une couche d'encapsulation 2 en recouvrement de la face principale 4a et de la ou des structures électroniques 3.

La couche d'encapsulation 2 peut être formée par un procédé de moulage et/ou de laminage à l'échelle du dispositif ou, pour des raisons d'économie, à l'échelle d'un substrat comprenant une pluralité de structures support sur lesquelles sont reportées des structures électroniques 3.

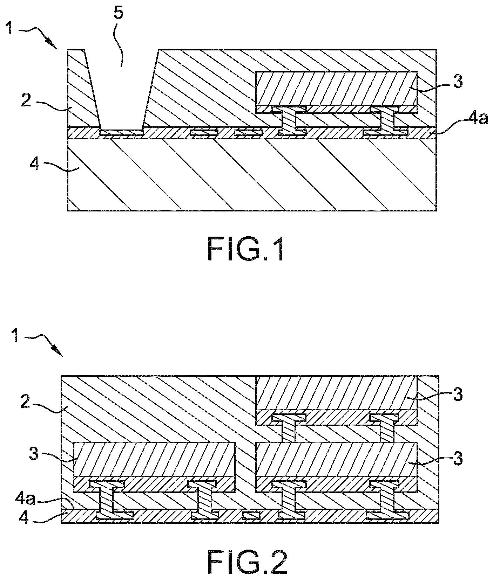

La figure 1 représente, en particulier, un dispositif électronique 1, qui comprend une structure électronique 3 reportée sur une structure support 4, et pourvue d'une couche d'encapsulation 2 en recouvrement de la structure électronique 3 et de la face principale 4a de la structure support 4.

De manière équivalente, le dispositif électronique 1 peut comprendre une pluralité de structures électroniques 3 interconnectées entre elles soit de manière directe soit via la structure support 4. Par exemple, tel qu'illustré à la figure 2, le dispositif électronique 1 peut comprendre deux structures électroniques 3, dites respectivement première structure électronique 3 et seconde structure électronique 3, reportées sur la face principale 4a de la structure support 4, et une troisième structure électronique 3 reportée sur la première structure électronique 3. Selon cette configuration, la couche d'encapsulation 2 est alors en recouvrement de la face principale 4a et des structures électroniques 3.

Cependant, un procédé d'encapsulation d'un dispositif électronique 1 tel que décrit précédemment n'est pas satisfaisant.

En effet, l'accès à la face principale 4a et/ou à la structure électronique 3, par exemple pour établir un contact électrique, peut nécessiter une étape de gravure, dite gravure profonde, pour la formation de tranchées ou de VIA 5 dans la couche d'encapsulation 2. Cependant, une telle couche d'encapsulation 2, dès lors qu'elle est mise en œuvre pour assurer une protection tant chimique que mécanique, est relativement résistante aux procédés de gravure connus, rendant ces derniers longs et coûteux.

Par ailleurs, une gravure profonde implique également la mise en œuvre d'une couche d'arrêt, par exemple une couche métallique, contraignant la conception du dispositif électronique 1. Un exemple d'un procédé est présenté dans le document US20140203380. La figure 11, par exemple,présente un MEMS comprenant différents chips. Ces chips sont enrobés , mais une ouverture doit être faite afin d'avoir accès à un chip de taille inférieure recouvert lors de cette opération.

Un but de la présente invention est donc de proposer un procédé d'exposition d'une région de la face principale et/ou de la ou des structures électroniques plus simple à mettre œuvre que les procédés connus de l'état de la technique.

Un autre but de la présente invention est également de proposer un procédé d'exposition d'une région de la face principale et/ou de la ou des structures électroniques ne nécessitant pas la mise en œuvre de gravure profonde.

Un autre but de la présente invention est de proposer un procédé d'exposition d'une région de la face principale et/ou de la ou des structures électroniques de manière à pouvoir coupler et aligner optiquement une fibre optique au niveau de la région exposée.

Un autre but de la présente invention est de proposer un procédé de fabrication de structures de couplage et d'alignement plus simple à mettre en œuvre et qui soit compatible avec les procédés connus de micro fabrication.

### EXPOSÉ DE L'INVENTION

Les buts de la présente invention sont, au moins en partie, atteints par un procédé d'exposition d'au moins une région d'une face, dite face avant, d'un dispositif électronique, le procédé comprenant les étapes suivantes :
a) une étape de collage d'un capot sur la face avant, le collage étant exécuté de sorte que le capot forme avec la région une cavité fermée, avantageusement hermétiquement fermée ;
b) la formation d'une couche d'encapsulation, d'une épaisseur E1, en recouvrement de la face avant et du capot ;
c) une étape d'amincissement de la couche d'encapsulation, l'étape d'amincissement comprenant le retrait d'une épaisseur de retrait E2, inférieure à l'épaisseur E1, de la couche d'encapsulation, l'épaisseur de retrait E2 étant adaptée pour qu'une ouverture soit formée dans le capot.

Selon un mode de mise en œuvre, le capot comprend un fond et une paroi latérale, l'étape de collage b) étant exécutée en mettant en contact un rebord de la paroi latérale avec la face avant.

Selon un mode de mise en œuvre, le fond du capot est recouvert d'une couche d'arrêt, l'étape d'amincissement étant en outre sélective de manière à graver sélectivement le capot par rapport à la couche d'arrêt.

Selon un mode de mise en œuvre, l'étape c) est suivie d'une étape d) de retrait de la couche d'arrêt, avantageusement l'étape d) est une étape de gravure chimique.

Selon un mode de mise en œuvre, l'étape b) est exécutée selon l'une des méthodes choisie parmi : collage avec une colle, collage par soudure avantageusement avec un matériau à base d'étain d'argent et de cuivre, collage par frittage.

Selon un mode de mise en œuvre, l'étape d'amincissement c) est exécutée par érosion mécanique.

Selon un mode de mise en œuvre, l'étape b) est exécutée par laminage d'une feuille de matériau d'encapsulation.

Selon un mode de mise en œuvre, l'étape b) est exécutée par injection/moulage d'une résine faite du matériau d'encapsulation

Selon un mode de mise en œuvre, le dispositif électronique comprend au moins une structure électronique reportée sur une face principale d'une structure support, la couche d'encapsulation formée à l'étape b) étant en recouvrement de la face principale et de l'au moins une structure électronique.

Selon un mode de mise en œuvre, l'au moins une région comprend une première région disposée sur la face principale de la structure support.

Selon un mode de mise en œuvre, l'au moins une région comprend une seconde région disposée sur la structure électronique.

Selon un mode de mise en œuvre, l'au moins une structure électronique comprend une pluralité de structures électroniques de hauteurs différentes, avantageusement, l'étape a) comprend le report d'une pluralité de capots sur une pluralité de régions disposées au niveau des structures électroniques, la profondeur des capots étant ajustée de sorte que chacun d'entre eux soit ouvert de manière, essentiellement, simultanée lors de l'étape c).

Selon un mode de mise en œuvre, à l'issue de l'étape d'amincissement la structure électronique est essentiellement en affleurement avec la surface libre de la couche d'encapsulation.

Selon un mode de mise en œuvre, le capot est rempli d'une résine.

Selon un mode de mise en œuvre, l'au moins une région comprend un coupleur de réseau.

Selon un mode de mise en œuvre, l'au moins une région comprend au moins une connexion électrique.

Selon un mode de mise en œuvre, l'au moins une région comprend une région sensible d'un dispositif ou capteur MEMS.

L'invention est également mise en œuvre pour la fabrication de structures de couplage et d'alignement d'au moins une fibre optique au niveau d'une zone de couplage optique d'une face, dite face avant, d'un dispositif optoélectronique , le procédé comprenant les étapes suivantes :
a) une étape de collage d'au moins un capot sur la face avant, le capot comprenant un fond et une paroi latérale, un premier capot parmi l'au moins un capot (600) étant en recouvrement de la zone de couplage optique ;
b) la formation d'une couche d'encapsulation, d'une épaisseur E1, en recouvrement de la face avant et de l'au moins un capot ;
c) une étape d'amincissement, l'étape d'amincissement comprenant le retrait du fond de l'au moins un capot et d'une épaisseur de retrait E2, inférieure à l'épaisseur E1, de la couche d'encapsulation, la paroi latérale de l'au moins un capot restante à l'issue de l'étape amincissement formant la structure de couplage et d'alignement.

Selon un mode de mise en œuvre, le collage du premier capot est précédé de la formation ou du report d'une optique de mise en forme du faisceau sur la zone de couplage optique.

Selon un mode de mise en œuvre, l'au moins une fibre optique est maintenue au niveau d'une de ses extrémités dans une ferrule, ladite une ferrule comprend une sortie optique disposée selon une face, dite face de couplage de la ferrule, la sortie optique étant en regard de la zone de couplage optique dès lors que l'alignement entre la ferrule et un élément de couplage optique, disposé au niveau de la zone de couplage, est effectif.

Selon un mode de mise en œuvre, la ferrule comprend un canal à l'intérieur duquel est insérée l'au moins une fibre optique, le canal étant pourvu d'un miroir oblique destiné à dévier un rayonnement, susceptible d'être guidé par l'au moins une fibre optique, en direction de la sortie optique.

Selon un mode de mise en œuvre, l'au moins un capot comprend en outre un second capot, dont la paroi latérale, dite seconde paroi, forme un volume interne, dit second volume interne, destiné à accueillir, par insertion, un ergot disposé sur la face de couplage et dont la surface périphérique présente une forme complémentaire à la forme définie par la seconde paroi, formant un élément de la structure de couplage et d'alignement de l'au moins une fibre optique.

Selon un mode de mise en œuvre, l'au moins un capot comprend un troisième capot, dont la paroi latérale, dite troisième paroi, forme un volume interne, dit troisième volume interne, destiné à accueillir, par insertion, un second ergot disposé sur la face de couplage et dont la surface périphérique présente une forme complémentaire à la forme définie par la troisième paroi, formant un élément de la structure de couplage et d'alignement de l'au moins une fibre optique.

Selon un mode de mise en œuvre, l'au moins un capot comprend une pluralité de compartiments destinés à être couplés chacun avec une fibre optique différente parmi l'au moins une fibre optique.

Selon un mode de mise en œuvre, la paroi du premier capot, dite première paroi, est agencée pour accueillir, par insertion dans un premier volume interne défini par ladite première paroi, un élément d'alignement en projection de la face de couplage et présentant une surface périphérique de forme complémentaire à la forme définie par la première paroi.

Selon un mode de mise en œuvre, le fond de l'au moins un capot est recouvert d'une couche d'arrêt, l'étape d'amincissement étant en outre sélective de manière à graver sélectivement le fond par rapport à la couche d'arrêt.

Selon un mode de mise en œuvre, l'étape c) est suivie d'une étape d) de retrait de la couche d'arrêt, avantageusement l'étape d) est une étape de gravure par voie humide ou par voie sèche.

Selon un mode de mise en œuvre, l'étape a) est exécutée selon l'une des méthodes choisie parmi : collage avec une colle polymère, collage par brasage (avantageusement avec un matériau à base d'étain, d'argent et de cuivre), collage par frittage.

Selon un mode de mise en œuvre, l'étape d'amincissement c) est exécutée par érosion mécanique.

Selon un mode de mise en œuvre, l'étape b) est exécutée par laminage d'une feuille de matériau d'encapsulation, ou par injection d'une résine d'encapsulation.

Selon un mode de mise en œuvre, le dispositif optoélectronique comprend au moins un composant électronique reporté sur une face principale d'une structure support, la couche d'encapsulation formée à l'étape b) étant en recouvrement de la face principale et de l'au moins une structure optoélectronique.

Selon un mode de mise en œuvre, la zone de couplage optique est disposée sur la face principale de la structure support.

Selon un mode de mise en œuvre, à l'issue de l'étape d'amincissement la structure optoélectronique est essentiellement en affleurement avec la surface libre de la couche d'encapsulation.

Selon un mode de mise en œuvre, la zone de couplage optique comprend un coupleur de réseau.

### BRÈVE DESCRIPTION DES DESSINS

D'autres caractéristiques et avantages apparaîtront dans la description qui va suivre du procédé d'exposition d'une région d'une face d'un dispositif électronique selon l'invention, donnés à titre d'exemples non limitatifs, en référence aux dessins annexés dans lesquels :
- la figure 1 est une représentation schématique d'un procédé d'exposition d'une région d'un dispositif électronique recouvert d'une couche d'encapsulation, selon l'état de l'art ;
- la figure 2 est une représentation schématique d'un dispositif microélectronique comprenant une structure support sur laquelle sont reportées des structures électroniques, ledit dispositif électronique étant recouvert d'une couche d'encapsulation ;
- les figures 3a à 3d sont une représentation schématique, selon un plan de coupe perpendiculaire à la face avant du dispositif électronique, du procédé selon la présente invention ;
- les figures 4a à 4e sont une représentation schématique, selon un plan de coupe perpendiculaire à la face avant du dispositif électronique, du procédé selon la présente invention mettant en œuvre une couche d'arrêt ;
- les figures 5a à 5e sont une représentation schématique, selon un plan de coupe perpendiculaire à la face avant du dispositif électronique, du procédé selon la présente invention mettant en œuvre une couche d'arrêt et un capot rempli d'une résine ;
- les figures 6a à 6b sont une représentation schématique, selon un plan de coupe perpendiculaire à la face avant du dispositif électronique, du procédé selon la présente invention mettant en œuvre une pluralité de structures électroniques ;
- la figure 7 est une représentation schématique, selon un plan de coupe perpendiculaire à la face avant du dispositif électronique, dudit dispositif susceptible d'être obtenue selon la présente invention et comprenant en plus une étape de sérigraphie destinée à combler avec un matériau conducteur l'espace interne du capot après l'étape c) ;
- la figure 8 est une représentation schématique, selon un plan de coupe perpendiculaire à la première face du substrat, d'un procédé de fabrication de capots ;
- les figures 9a à 9e sont des représentations schématiques, selon un plan de coupe perpendiculaire à la face avant du dispositif électronique, de la mise en œuvre du procédé d'exposition pour la fabrication de structures de couplage et d'alignement d'au moins une fibre optique avec un dispositif optoélectronique selon la présente invention ;
- les figures 10a et 10b sont des représentations schématiques, selon un plan de coupe perpendiculaire à la face avant du dispositif électronique, de couplage d'une fibre optique avec une zone de couplage optique, selon la présente invention.

### EXPOSÉ DÉTAILLÉ DE MODES DE RÉALISATION PARTICULIERS

La présente invention concerne un procédé destiné à former une ouverture traversante dans une couche d'encapsulation en recouvrement d'un dispositif électronique, l'ouverture traversante exposant à l'environnement extérieur une région de la face avant dudit dispositif.

Le procédé comprend en particulier le collage d'un capot destiné à isoler dans une cavité ladite région, et, ensuite, à former la couche d'encapsulation. Une étape d'amincissement partiel de la couche d'encapsulation, par exemple par abrasion mécanique (« Grinding » selon la terminologie Anglo-Saxonne), permet alors d'ouvrir la cavité formée par le capot, et ainsi exposer l'intérieur de ladite cavité.

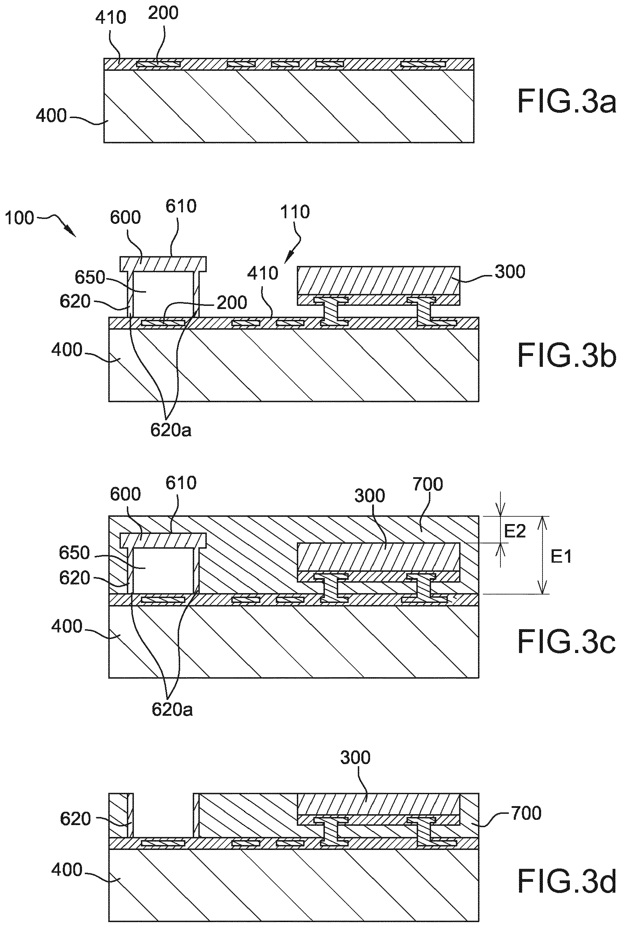

Ainsi, aux figures 3a à 7, on peut voir des exemples de mise en œuvre du procédé d'exposition d'une région selon la présente invention.

En particulier, le procédé est mis en œuvre sur un dispositif électronique 100 (figures 3b, 4b, 5b).

Le dispositif électronique 100 comprend au moins une région 200 sur sa face avant 110. Une région 200, au sens de la présente invention, correspond à une région d'intérêt et dont la surface, par rapport à celle de la face avant 110, est limitée. Il s'agit donc d'une région d'étendue restreinte.

L'au moins une région 200 peut, par exemple, comprendre au moins une connexion électrique, et/ou un coupleur de réseau, par exemple un coupleur de réseau optique.

De manière complémentaire ou alternative, l'au moins une région 200 peut comprendre un dispositif microélectronique, d'une région sensible d'un capteur MEMS destinée à être exposée à l'environnement extérieur à l'issue du procédé d'exposition selon la présente invention. Par « région sensible d'un capteur MEMS », on entend une région destinée à être exposée à l'environnement extérieur et dont la fonction est de collecter une information dudit environnement. L'information peut alors être une température, une pression.

L'au moins une région 200 peut prendre n'importe quelle forme. Elle peut en particulier être de forme carrée, rectangulaire, ou encore ronde. L'au moins une région 200 peut également avoir des dimensions comprises entre 40 µm et 2 mm.

Par ailleurs, le dispositif électrique 100 peut comprendre au moins une structure électronique 300 (figure 3b, 4b, 5b, 6a) reportée sur une structure support 400.

En particulier, l'au moins une structure électronique 300 peut être reportée sur une face principale 410 de la structure support 400.

Il est entendu que la face avant 110 d'un tel dispositif correspond à la face principale 410 et à la surface exposée de la structure électronique 300 après report de ladite structure 300.

L'au moins une structure électronique 300 peut être reportée par une étape de collage, par exemple, selon une méthode de placement individuel de ladite au moins une structure électronique 300 sur la face principale 410 (« Pick and Place » selon la terminologie Anglo-Saxonne).

À cet égard, un substrat support peut comprendre une pluralité de structures support 400 agencées de manière matricielle, et sur chacune desquelles sont reportées de manière individuelle au moins une structure électronique 300.

Le substrat support peut comprendre un matériau semi-conducteur, par exemple du silicium, sur lequel sont fabriquées les structures support 400.

Les structures support 400 peuvent être des interposeurs, ou comprendre des circuits d'interconnexion destinées à assurer une interconnectivité électrique au niveau de l'au moins une structure électronique 300.

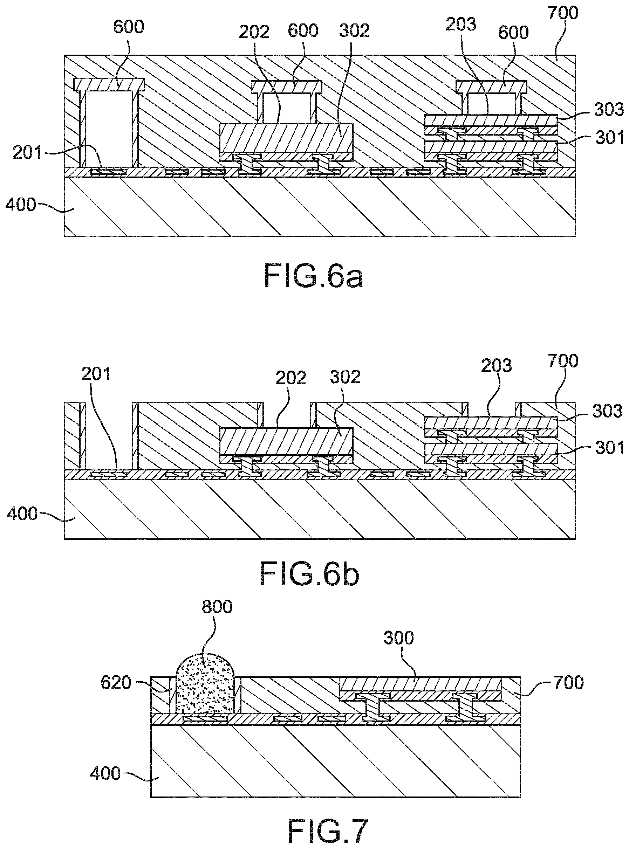

En particulier, une structure support 400 peut assurer l'interconnectivité au sein d'une même structure électronique 300 et/ou entre plusieurs structures électroniques 300 reportée(s) sur la face principale 410 de ladite structure support 400 (figure 6a).

Le dispositif électronique 100 peut comprendre une unique structure électronique 300 (figures 3b, 4b, 5b), ou de manière alternative, plusieurs structures électroniques 300 (figures 6a et 6b). Dès lors que plusieurs structures électroniques 300 sont considérées, ces dernières peuvent présenter des hauteurs différentes.

Par exemple, et en référence à la figure 6a, le dispositif électronique 100 peut comprendre deux structures électroniques 300 dites, respectivement, première structure électronique 301 et seconde structure électronique 302 reportées sur la face principale 410, et une autre structure électronique 300, dite troisième structure électronique 303 reportée sur la première structure électronique 301.

Les première 301, seconde 302 et troisième 303 structures électroniques peuvent présenter des hauteurs différentes.

Par « hauteur d'une structure électronique », on entend une dimension selon une direction perpendiculaire à la surface sur laquelle elle est reportée.

L'au moins une région 200 peut être disposée sur la face principale 410 et/ou sur l'au moins une structure électronique 300.

En particulier, le dispositif électronique 100 peut comprendre une pluralité de régions 200. Par exemple, et en référence aux figures 6a et 6b, le dispositif peut comprendre une région 200, dite première région 201, disposée sur la face principale 410, et une autre région 200, dite seconde région 202, disposée sur la surface exposée de la seconde structure électronique 302.

Le procédé selon la présente invention comprend alors une étape a) de collage d'un capot 600 sur la face avant 110.

Par « capot », on entend une pièce ou un élément comprenant un volume interne ouvert et qui, lorsqu'il est apposé sur une surface, forme avec ladite surface une cavité fermée.

Selon la présente invention, le capot 600 positionné de manière à former avec la première région une cavité 650 fermée (figures 3b, 4b, 5b), avantageusement une cavité hermétiquement fermée. En d'autres termes, toutes les fonctionnalités, électroniques et/ou optiques formées sur la région 200 se trouvent dans la cavité 650 à l'issue de l'étape a).

Par ailleurs, il est entendu que dès lors que le dispositif électronique 100 est pourvu d'une pluralité de régions 200, l'étape a) comprend le collage d'une pluralité de capots 600.

L'étape a) peut être exécutée par placement individuel des capots 600.

Le capot 600 peut comprendre un fond 610 et une paroi latérale 620 (figures 3b, 3c, 4b, 4c, 5b, 5c).

La paroi latérale 620 peut être d'une épaisseur comprise entre 50 µm et 200 µm, par exemple 100 µm.

Le fond 610 peut être d'une épaisseur comprise entre 50 µm et 200 µm, par exemple 100 µm.

Le capot 600 peut être obtenu selon des techniques de micro fabrication qui impliquent une étape de photolithographie, une étape de gravure (par exemple une gravure sèche), et une étape de séparation individuelle des capots (« singulation » selon la terminologie Anglo-Saxonne).

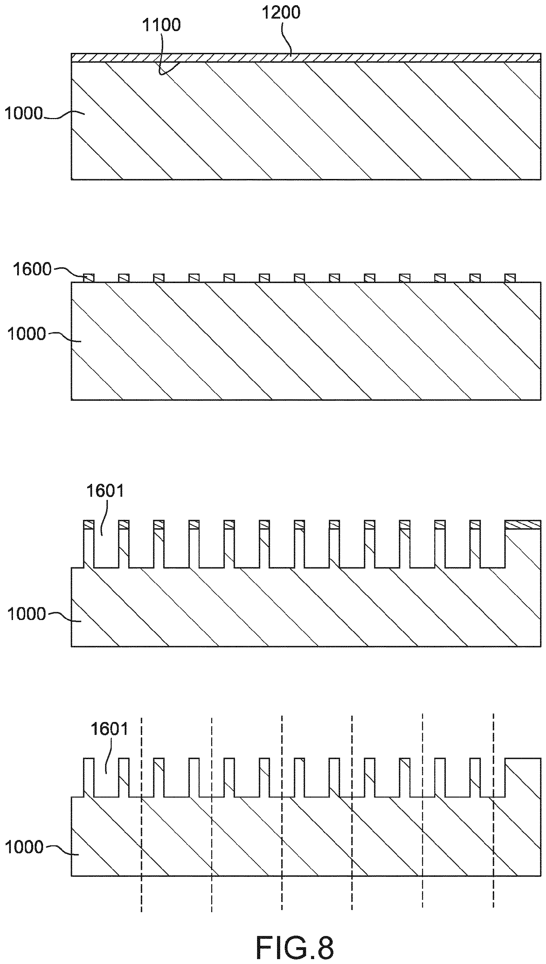

A titre d'exemple, la figure 8 illustre les différentes étapes d'un procédé de fabrication de capots.

Ledit procédé comprend la fourniture d'un substrat 1000, par exemple un substrat de silicium dont une face, dite première face 1100, est recouverte d'une couche d'oxyde de silicium 1200. La couche d'oxyde de silicium peut par exemple être obtenue par une oxydation thermique du substrat 1000.

Cette étape est suivie de la définition des motifs 1600 des capots 600 par un procédé photo lithographique au niveau de la couche d'oxyde de silicium.

Une étape de gravure sèche des motifs 1600 permet alors de révéler le volume interne 1601 des capots 600.

Une étape de séparation individuelle des capots 600 est finalement exécutée.

Il est entendu que ce procédé de fabrication des capots 600 n'est donné qu'à titre d'exemple.

Le collage des capots 600 peut être exécuté en mettant en contact le rebord 620a de la paroi latérale 620 avec la face avant 110.

Il est entendu qu'à l'issue de l'étape de collage a), la surface de la région 200 est circonscrite dans un contour défini par le rebord 620a.

De manière particulièrement avantageuse, le collage peut être exécuté avec une colle étendue sur le rebord 620a.

Toujours de manière avantageuse, le collage du capot 600 peut être exécuté par soudure, par exemple une soudure impliquant un matériau fusible à base d'étain, d'argent et de cuivre d'un côté et un métal de l'autre côté pour assurer un bon mouillage du matériau fusible.

Enfin, le collage du capot 600 peut également être exécuté par frittage.

Le procédé d'exposition d'au moins une région 200 comprend également une étape b) de formation d'une couche d'encapsulation 700 d'une épaisseur E1 et en recouvrement de la face avant 110 et du capot 600 (figures 3c, 4c, 5c, 6a).

Par « épaisseur d'une couche », on entend sa dimension selon une direction perpendiculaire à la surface sur laquelle elle repose.

Il est entendu que dès lors que le dispositif électronique 100 comprend une structure support 400 et une structure électronique 300, la couche d'encapsulation 700 est en recouvrement de la face principale 410 et de la surface exposée de la structure électronique 300.

La couche d'encapsulation 700 peut être formée à l'échelle du dispositif électronique 100 ou à l'échelle du substrat support.

La couche d'encapsulation 700 peut être, par exemple, formée par un procédé de laminage, avantageusement sous vide, d'une feuille faite d'un matériau de moulage.

Par « sous vide », on entend une pression atmosphérique inférieure à 10 mBar.

Le matériau de moulage est adapté pour assurer une tenue mécanique du dispositif électronique 100, mais également pour le protéger des conditions environnementales auxquelles il se trouve exposé.

À cet égard, le matériau de moulage peut comprendre soit des films ou résines à base d'époxy avec ou sans particules de silices, soit des films ou résines à base de silicone.

Le procédé de laminage peut comprendre une élévation de température, par exemple être exécuté entre 60°C et 200 °C, de manière à ramollir le matériau de moulage, et permettre à ce dernier un remplissage des interstices susceptibles d'être présents sur la face avant 110.

L'épaisseur E1 peut être comprise entre 50 µm et 400 µm, par exemple 200 µm.

Le procédé selon l'invention comprend également une étape c) d'amincissement (figures 3d, 4d, 5d). L'étape d'amincissement comprend le retrait d'une épaisseur de retrait E2 (figures 3c, 4c, 5c) de la couche amincissement, l'épaisseur de retrait E2 étant inférieure à l'épaisseur E1.

L'épaisseur de retrait E2, au sens de la présente invention, est cependant suffisante pour former une ouverture dans le capot 600.

En d'autres termes, lors de l'étape d'amincissement c), une partie du capot 600 est également retirée, de manière à rendre accessible une partie du volume interne dudit capot 600. Ainsi, l'étape c) génère un retrait du fond 610, et ne laisse que la paroi latérale 620.

De manière particulièrement avantageuse, l'étape d'amincissement peut être exécutée par érosion mécanique.

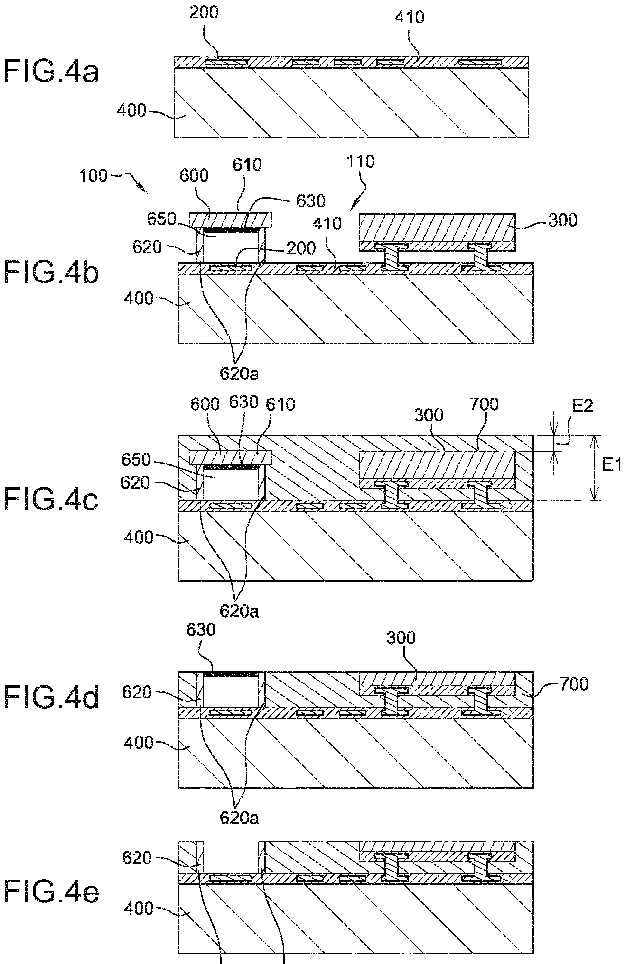

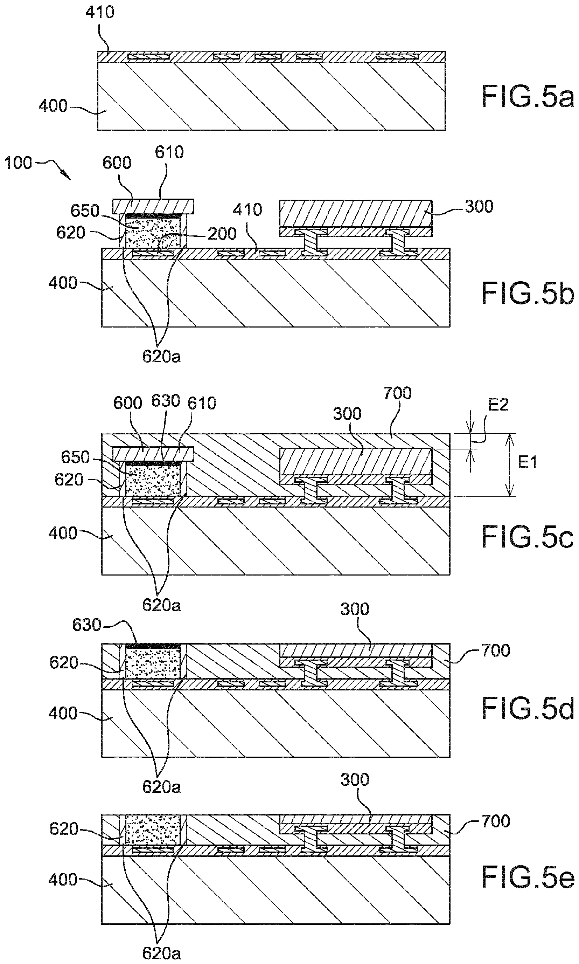

Par ailleurs, le fond 610 du capot 600 peut comprendre une couche d'arrêt 630, par exemple une couche d'oxyde de silicium (figures 4b-4d, 5c et 5d), au niveau de laquelle l'étape c) s'arrête. La couche d'arrêt 630 peut également comprendre une résine qui remplit au moins en partie la cavité 650.

Il est entendu que la couche d'arrêt se trouve dans le volume interne du capot 600.

De manière avantageuse, et en présence de la couche d'arrêt 630, l'étape c) d'amincissement peut être sélective et retirer préférentiellement le capot par rapport à la couche d'arrêt 630.

Dans ces conditions, l'étape c) peut être suivie d'une étape d) de gravure, avantageusement une gravure par voie humide, de la couche d'arrêt. Par exemple, dans le cas d'une couche d'arrêt 630 faite de dioxyde de silicium, la gravure humide peut comprendre l'action d'une solution d'acide fluorhydrique. Dans le cas d'une couche d'arrêt 630 faite de résine, la gravure de ladite couche d'arrêt 630 peut être exécutée par voie sèche, avantageusement par gravure sèche, encore plus avantageusement par une gravure sèche mettant en œuvre un plasma par exemple un plasma d'oxygène.

La mise en œuvre de la couche d'arrêt 630 permet de limiter la contamination particulaire pouvant survenir lors de l'étape c) d'amincissement.

Toujours de manière avantageuse, à l'issue de l'étape c), la structure électronique 300 peut être essentiellement en affleurement de la couche d'encapsulation 700 (figures 3d, 4d, 5d).

De manière alternative, différents capots 600 peuvent être collés sur la face principale 410 et sur la ou les structures électroniques 301, 303 (figures 6a et6b). Selon cette configuration, les différents capots peuvent présenter des profondeurs différentes de manière à être ouverts simultanément lors de l'étape c). Il est entendu que le fond 610 des capots peut être recouvert de la couche d'arrêt 630.

La considération de plusieurs capots 600, chacun d'une profondeur différente, est avantageusement mise à profit dès lors qu'une pluralité de structures électroniques 300 de hauteurs différentes sont reportées sur la structure support 400.

En particulier, dès lors qu'il s'agit d'exposer sur chacune desdites structures électronique 300 de hauteur différente une région 200, il est possible d'ajuster la profondeur de chacun des capots 600 considérés de sorte que chacun d'entre eux soit ouvert de manière simultanée lors de l'étape c) (figures 6a et 6b).

Cette approche est particulièrement avantageuse pour les capteurs ou Microsystèmes qui nécessitent un nombre de connexion externes limité.

Ainsi, l'invention, telle qu'elle est présentée, permet par exemple d'accéder à des zones de test de dispositifs optiques, ou de réaliser des connexions filaires (« Wire Bonding » selon la terminologie Anglo-Saxonne).

En relation avec la figure 7, une étape e) de réalisation de contact 800 au niveau de la région 300 exposée peut être réalisée. L'étape e) peut alors être exécutée par sérigraphie.

De manière avantageuse, et en relation avec les figures 5a à 5e, le volume interne du capot peut être rempli d'une résine, par exemple une résine présentant des propriétés de transparence suffisantes pour autoriser un couplage optique entre la région 200 et un dispositif optique, via par exemple une fibre optique.

Le procédé selon la présente invention peut avantageusement être mis en œuvre pour le couplage et l'alignement d'au moins une fibre optique au niveau d'une zone de couplage optique de l'au moins une région. En particulier, la paroi latérale de l'au moins un capot à l'issue de l'étape c) d'amincissement forme une structure de couplage et d'alignement destinée à permettre un optique entre l'au moins une fibre optique et le dispositif optoélectronique. En particulier, la paroi latérale forme une voie de passage pour la lumière. Les fibres optiques peuvent être maintenues dans une ferrule qui présente des structures d'alignement destinées à coopérer avec la structure de couplage et d'alignement du dispositif optoélectronique.

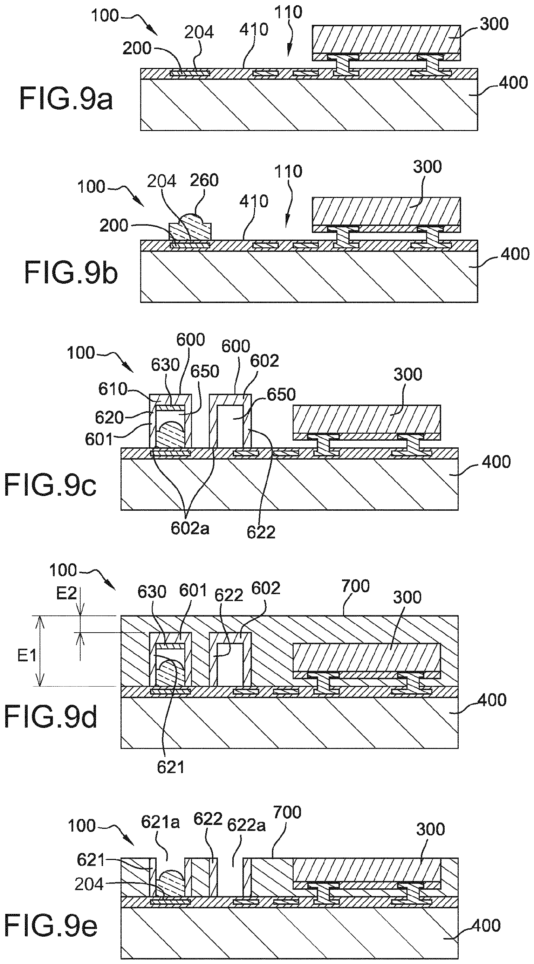

Ainsi, aux figures 9a à 9e, on peut voir des exemples de mise en œuvre du procédé d'exposition pour la fabrication de structures de couplage et d'alignement.

Ce procédé reprend pour l'essentiel les étapes a), b) et c) précédemment décrites.

L'au moins une région 200 comprend une zone de couplage optique 204 (figure 9a et 9b).

La zone de couplage optique 204 comprend un élément de couplage optique, qui est par exemple, et de manière non limitative, un réseau de couplage. Ledit élément de couplage optique fonctionne en émission et/ou en réception. Une zone de couplage optique, au sens de la présente invention, correspond à une région d'intérêt et dont la surface, par rapport à celle de la face avant 110, est limitée. Il s'agit donc d'une région d'étendue restreinte.

De manière avantageuse, la zone de couplage optique 204 peut comprendre un coupleur de réseau.

La zone de couplage optique 204 peut prendre n'importe quelle forme. Elle peut en particulier être de forme carrée, rectangulaire, ou encore ronde. L'au moins une zone de couplage optique peut avoir des dimensions comprises entre 1 µm et 2 mm, avantageusement entre 20 µm et 2 mm.

L'élément de couplage optique peut prendre n'importe quelle forme permettant sa fonction de couplage de la lumière. L'élément de couplage optique peut avoir des dimensions comprises entre 1 µm et 200 µm, avantageusement entre 10 µm et 100 µm.

Par ailleurs, le dispositif optoélectronique 100 peut comprendre l'au moins une structure électronique 300 (figures 9a à 9e) reporté sur la structure support 400. Tel que décrit précédemment, l'au moins une structure électronique 300 peut être reportée sur la face principale 410 (figure 9a et 9b) de la structure support 400.

Les techniques de report sont connues de l'homme du métier et peuvent notamment comprendre une étape de brasage, de collage, ou soudage par exemple.

À cet égard, un substrat support peut comporter une pluralité de structures support 400 agencées par exemple selon un pavage rectangulaire, et sur chacune desquelles sont reportées de manière individuelle l'au moins une structure électronique 300.

Le substrat support peut comprendre un matériau semi-conducteur, par exemple du silicium, sur lequel sont fabriquées ou reportées les structures support 400.

Les structures support 400 peuvent être des interposeurs, ou comprendre des circuits d'interconnexion destinées à assurer une interconnectivité électrique et/ou optique au niveau de l'au moins une structure électronique 300.

Une structure support 400 peut assurer l'interconnectivité au sein d'une même structure électronique 300 et/ou entre plusieurs structures électroniques 300 reportée(s) sur la face principale 410 de ladite structure support 400.

Le dispositif optoélectronique 100 peut comprendre une unique structure électronique 300, ou de manière alternative, plusieurs structures électroniques 300.

La zone de couplage optique 204 peut être disposée sur la face principale 410 et/ou sur l'au moins une structure électronique 300.

L'étape a) de collage de l'au moins un capot 600 sur la face avant 110 est illustrée à la figure 9c. En particulier, un premier capot 601 parmi l'au moins un capot est collé en recouvrement de la zone de couplage optique 204.

L'au moins un capot 600 est alors positionné de manière à former, avec la région sur laquelle il est collé, une cavité 650 fermée (figure 9c), et avantageusement une cavité hermétiquement fermée. En d'autres termes, toutes les fonctionnalités électroniques et/ou optiques, placées au niveau de la zone de couplage optique, se trouvent protégées dans la cavité 650 à l'issue de l'étape a).

L'étape a) peut être exécutée par placement individuel des capots 600, avec une précision en position de 5 à 10 µm.

L'au moins un capot 600 peut comprendre un fond 610 et une paroi latérale 620 (figure 9c).

La paroi latérale 620 peut être d'une épaisseur comprise entre 50 µm et 200 µm, par exemple 100 µm.

Le fond 610 peut être d'une épaisseur comprise entre 50 µm et 200 µm, par exemple 100 µm.

Le collage de l'au moins un capot 600 peut être exécuté en mettant en contact le rebord 620a de la paroi latérale 620 avec la face avant 110.

Il est entendu qu'à l'issue de l'étape de collage a), la surface de la zone de couplage optique 204 est circonscrite dans un contour défini par le rebord 620a du premier capot 601.

De manière avantageuse, le collage peut être exécuté avec une colle étendue sur le rebord 620a.

Toujours de manière avantageuse, le collage de l'au moins un capot 600 peut être exécuté par brasage, par exemple un brasage impliquant un matériau fusible à base d'étain, d'argent et de cuivre d'un côté et un métal de l'autre côté pour assurer un bon mouillage du matériau fusible.

Enfin, le collage du capot 600 peut également être exécuté par frittage.

L'étape a) de collage d'au moins un capot 600 peut être précédée d'une étape de fabrication ou du report d'une optique de mise en forme de faisceau 260 sur la zone de couplage optique 200 (figure 9b). Cette optique de mise en forme 260 peut être une lentille collimatrice, et est destinée à élargir le faisceau lumineux susceptible d'être émis ou reçu au niveau de la zone de couplage optique 204. En particulier, le plan focal de la lentille collimatrice peut être au niveau de la zone de couplage optique 204. Le collimateur optique 260 peut être formé directement sur la zone de couplage optique par un procédé photo lithographique ou par report d'une lentille préformée. Il peut comprendre une pluralité d'éléments (par exemple une matrice de microlentilles) destinés à mettre en forme une pluralité de faisceaux.

L'étape b) de formation d'une couche d'encapsulation 700 d'une épaisseur E1 et en recouvrement de la face avant 110 et de l'au moins un capot 600 est illustrée à la figure 9d.

Il est entendu que dès lors que le dispositif optoélectronique 100 comprend une structure support 400 et une structure électronique 300, la couche d'encapsulation 700 est en recouvrement de la face principale 410 et de la surface exposée de la structure électronique 300.

La couche d'encapsulation 700 peut être formée à l'échelle du dispositif optoélectronique 100 ou à l'échelle du substrat support.

La couche d'encapsulation 700 peut être, par exemple, formée par un procédé de laminage, avantageusement sous vide, d'une feuille faite d'un matériau de moulage.

Le matériau de moulage est adapté pour assurer une tenue mécanique du dispositif optoélectronique 100, mais également pour le protéger des conditions environnementales auxquelles il se trouve exposé.

À cet égard, le matériau de moulage peut comprendre soit des films ou résines à base d'époxy avec ou sans particules de silices, soit des films ou résines à base de silicone.

Le procédé de laminage peut comprendre une élévation de température, par exemple être exécuté entre 60°C et 200 °C, de manière à ramollir le matériau de moulage, et de sorte que ce dernier assure un remplissage parfait des interstices susceptibles d'être présents sur la face avant 110.

L'épaisseur E1 peut être comprise entre 5 µm et 2 mm, par exemple 200 µm.

L'étape c) d'amincissement est illustrée à la figure 9e. L'étape d'amincissement comprend le retrait du fond 610 de l'au moins un capot 600 et d'une épaisseur de retrait E2, inférieure à l'épaisseur E1, de la couche d'encapsulation, la paroi latérale 610 de l'au moins un capot 600 restante à l'issue de l'étape amincissement formant la structure de couplage et d'alignement (figures 9d et 9e) et une voie de passage de la lumière.

Il est entendu que l'étape d'amincissement permet le retrait, en une seule étape, d'une épaisseur E2 de la couche d'encapsulation et du fond 610 de l'au moins un capot 600.

De manière particulièrement avantageuse, l'étape d'amincissement peut être exécutée par érosion mécanique (« grinding » selon la terminologie anglo-saxonne).

Par ailleurs, le fond 610 du capot 600 peut comprendre une couche d'arrêt 630 (figures 9c et 9d), par exemple une couche d'oxyde de silicium, au niveau de laquelle l'étape c) s'arrête.

Il est entendu que la couche d'arrêt 630 peut se trouver dans le volume interne du capot 600.

De manière avantageuse, et en présence de la couche d'arrêt 630, l'étape c) d'amincissement peut être sélective et retirer préférentiellement le fond du capot par rapport à la couche d'arrêt 630.

Dans ces conditions, l'étape c) peut être suivie d'une étape d) de gravure, avantageusement une gravure par voie humide, de la couche d'arrêt. Par exemple, dans le cas d'une couche d'arrêt 630 faite de dioxyde de silicium, la gravure humide peut comprendre l'action d'une solution d'acide fluorhydrique.

L'étape d) peut, de manière alternative, comprendre une gravure par voie sèche, par exemple une gravure exécutée à l'aide d'un plasma.

La mise en œuvre de la couche d'arrêt 630 permet de limiter la contamination particulaire du volume interne qui pourrait survenir lors de l'étape c) d'amincissement en l'absence de cette couche.

Toujours de manière avantageuse, à l'issue de l'étape c), la structure électronique 300 peut se retrouver essentiellement en affleurement de la couche d'encapsulation 700 (figure 9e).

La structure de couplage et d'alignement 204 formée sur le dispositif 400 selon la présente invention est ainsi agencée pour permettre le couplage et l'alignement optique d'au moins une fibre optique 800 avec l'élément de couplage optique. En particulier, l'au moins une fibre optique 800 est maintenue dans une ferrule 500, laquelle ferrule 500 coopère avec la structure de couplage et d'alignement fabriquée sur le dispositif 400.

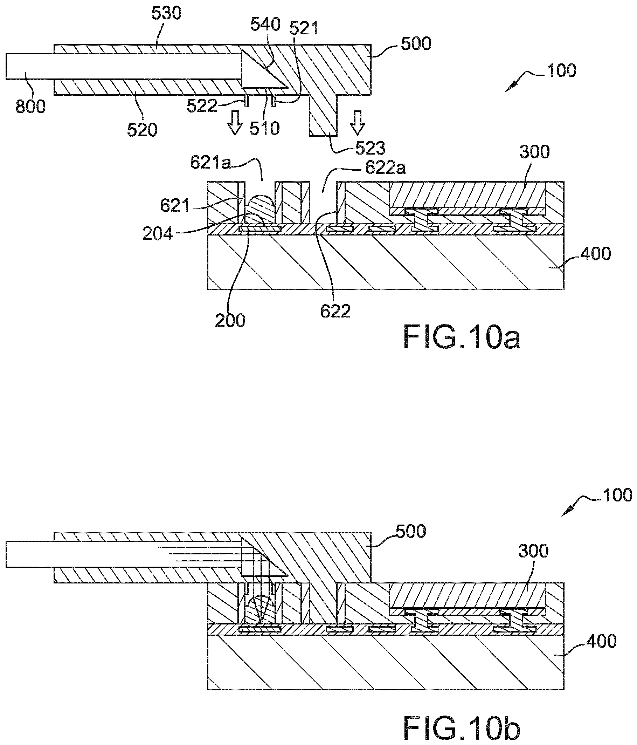

La ferrule 500 peut comprendre une sortie optique 510 disposée selon une face, dite face de couplage 520 de la ferrule et qui se trouve en regard de l'élément de couplage optique dès lors qu'un couplage est effectif (figure 10b).

La ferrule 500, par définition, comprend un canal 530 à l'intérieur duquel est insérée l'au moins une fibre optique 800. De manière complémentaire, la ferrule 500 peut également comprendre une optique, par exemple un miroir oblique 540 en regard d'une extrémité de l'au moins une fibre optique 800 et agencé pour dévier le faisceau de lumière émis au niveau de ladite extrémité en direction de la sortie optique 510 (Ce miroir peut être courbe, de façon à former un faisceau de lumière collimaté en sortie de la face de couplage de la ferrule).

Selon un premier exemple de mise en œuvre illustré aux figures 9e, 10a et 10b, la paroi latérale 621 du premier capot 601 (figure 10d), dite première paroi 621, forme un premier volume interne 621a servant de voie de passage pour la lumière.

La forme de la première paroi 621 peut être carrée, rectangulaire ou circulaire.

Le premier volume interne 621a peut être compartimenté, par exemple par des cloisons internes (en d'autres termes, plusieurs voies de passage pour la lumière sont formées).

Toujours selon ce premier exemple de mise en œuvre, l'au moins un capot 600 peut également comprendre un second capot 602 (figure 9d) dont la paroi latérale 622, dite seconde paroi 622, forme un volume interne dit second volume interne 622a.

Le second volume interne 622a peut être agencé pour accueillir, par insertion, un ergot 523 disposé sur la face de couplage 520. De manière avantageuse, l'ergot 523 présente une forme complémentaire au second volume interne 622a. De manière avantageuse, les dimensions de l'ergot 523 et de la paroi latérale 622 peuvent être ajustées pour assurer une tolérance de positionnement mécanique passif meilleure que 10 µm.

De manière complémentaire ou alternative, le premier volume interne 621a peut être agencé pour accueillir, par insertion, un élément d'alignement 521 formé en projection sur la face de couplage 520. De manière particulièrement avantageuse, l'élément d'alignement 521 comprend une première surface périphérique 522.

En particulier, la première surface périphérique 522 peut présenter une forme complémentaire à la forme définie par la première paroi 621.

Selon un deuxième exemple de mise en œuvre, complémentaire au premier exemple, l'au moins un capot 600 peut comprendre un troisième capot (non représenté sur les figures) dont la paroi latérale, dite troisième paroi, forme un volume interne dit troisième volume interne.

Le troisième volume interne peut être agencé pour accueillir, par insertion, un second ergot disposé sur la face de couplage 520. De manière avantageuse, le second ergot présente une forme complémentaire au troisième volume interne. Il est entendu que le second ergot (non référencé sur les figures) a une forme similaire à celle de l'ergot 523.

Selon la présente invention, les structures de couplage et d'alignement sont formées de manière intégrée, et leur fabrication n'implique donc que des étapes compatibles avec les techniques connues de micro fabrication.

Le dégagement des capots et l'amincissement des puces 300 se fait en une seule étape.

Par ailleurs, ce procédé présente un coût également compatible avec les requis des industries de la microélectronique, des MEMS, et des dispositifs optoélectroniques.

## Revendications

1. Procédé d'exposition d'au moins une région (200) d'une face, dite face avant (110), d'un dispositif électronique (100), le procédé comprenant les étapes suivantes :
a) une étape de collage d'au moins un capot (600) sur la face avant (110), le collage étant exécuté de sorte que le capot (600) forme avec la région (200) une cavité (650) fermée, avantageusement hermétiquement fermée ;
b) la formation d'une couche d'encapsulation (700), d'une épaisseur E1, en recouvrement de la face avant (110) et de l'au moins un capot (600) ;
c) une étape d'amincissement de la couche d'encapsulation (700), l'étape d'amincissement comprenant le retrait d'une épaisseur de retrait E2, inférieure à l'épaisseur E1, de la couche d'encapsulation (700), l'épaisseur de retrait E2 étant adaptée pour qu'une ouverture soit formée dans le capot (600).

2. Procédé selon la revendication 1, dans lequel le capot (600) comprend un fond (610) et une paroi latérale (620), l'étape de collage b) étant exécutée en mettant en contact un rebord de la paroi latérale (620) avec la face avant (110).

3. Procédé selon la revendication 2, dans lequel le fond (610) du capot (600) est recouvert d'une couche d'arrêt (630), l'étape d'amincissement étant en outre sélective de manière à graver sélectivement le capot (600) par rapport à la couche d'arrêt (630).

4. Procédé selon la revendication 3, dans lequel l'étape c) est suivie d'une étape d) de retrait de la couche d'arrêt (630), avantageusement l'étape d) est une étape de gravure chimique ou une gravure sèche.

5. Procédé selon l'une des revendications 1 à 4, dans lequel l'étape a) est exécutée selon l'une des méthodes choisie parmi : collage avec une colle, avantageusement une colle polymère, collage par soudure ou brasage avantageusement avec un matériau à base d'étain d'argent et de cuivre, collage par frittage.

6. Procédé selon l'une des revendications 1 à 5, dans lequel l'étape d'amincissement c) est exécutée par érosion mécanique.

7. Procédé selon l'une des revendications 1 à 6, dans lequel l'étape b) est exécutée par laminage d'une feuille de matériau d'encapsulation, ou par injection d'une résine faite du matériau d'encapsulation.

8. Procédé selon l'une des revendications 1 à 7, dans lequel l'au moins une région (200) comprend une région de couplage optique (204), et un premier capot (601) parmi l'au moins un capot (200) est configuré pour former une structure de couplage et d'alignement d'au moins une fibre optique (800) au niveau de la région de couplage optique.

9. Procédé selon la revendication 8, dans lequel l'étape a) est précédée de la formation ou du report d'une optique de mise en forme de faisceau (260) sur la zone de couplage optique (204).

10. Procédé selon la revendication 8 ou 9, dans lequel l'au moins une fibre optique (800) est maintenue au niveau d'une de ses extrémités dans une ferrule (500), ladite une ferrule (500) comprend une sortie optique (510) disposée selon une face, dite face de couplage (520) de la ferrule, la sortie optique (510) étant en regard de la zone de couplage optique (204) dès lors que l'alignement entre la ferrule et un élément de couplage optique (200a), disposé au niveau de la zone de couplage (204), est effectif.

11. Procédé selon la revendication 10, dans lequel la ferrule comprend un canal (530) à l'intérieur duquel est insérée l'au moins une fibre optique (800), le canal (530) étant pourvu d'un miroir oblique (540) destiné à dévier un rayonnement, susceptible d'être guidé par l'au moins une fibre optique (800), en direction de la sortie optique (510).

12. Procédé selon la revendication 10 ou 11, dans lequel la paroi du premier capot (601), dite première paroi (621), est agencée pour accueillir, par insertion dans un premier volume (621a) interne défini par ladite première paroi (621), un élément d'alignement (521) en projection de la face de couplage (520) et présentant une surface périphérique de forme complémentaire à la forme définie par la première paroi (621).

13. Procédé selon l'une des revendications 10 à 12, dans lequel l'au moins un capot (600) comprend en outre un second capot (602), dont la paroi latérale (620), dite seconde paroi (622), forme un volume interne, dit second volume (622a) interne, destiné à accueillir, par insertion, un ergot (523) disposé sur la face de couplage (520) et dont la surface périphérique présente une forme complémentaire à la forme définie par la seconde paroi (622), formant un élément de la structure de couplage et d'alignement de l'au moins une fibre optique.

14. Procédé selon la revendication 13, dans lequel l'au moins un capot (600) comprend un troisième capot, dont la paroi latérale (620), dite troisième paroi, forme un volume interne, dit troisième volume interne, destiné à accueillir, par insertion, un second ergot disposé sur la face de couplage (520) et dont la surface périphérique présente une forme complémentaire à la forme définie par la troisième paroi, formant un élément de la structure de couplage et d'alignement de l'au moins une fibre optique.

15. Procédé selon l'une des revendications 1 à 14, dans lequel le dispositif électronique (100) comprend au moins une structure électronique (300) reportée sur une face principale (410) d'une structure support (400), la couche d'encapsulation (700) formée à l'étape b) étant en recouvrement de la face principale (410) et de l'au moins une structure électronique (300), avantageusement l'au moins une région (200) comprend une première région (201) disposée sur la face principale (410) de la structure support (400).

16. Procédé selon la revendication 15, dans lequel l'au moins une région (200) comprend une seconde région (202) disposée sur la structure électronique (300).

17. Procédé selon les revendications 1 à 16, dans lequel l'au moins une structure électronique (300) comprend une pluralité de structures électroniques (302, 303) de hauteurs différentes, avantageusement, l'étape a) comprend le report d'une pluralité de capots (600) sur une pluralité de régions (202, 203) disposées au niveau des structures électroniques (302, 303), la profondeur des capots (600) étant ajustée de sorte que chacun d'entre eux soit ouvert de manière, essentiellement, simultanée lors de l'étape c).

18. Procédé selon la revendication 16 ou 17, dans lequel à l'issue de l'étape d'amincissement la structure électronique (300) est essentiellement en affleurement avec la surface libre de la couche d'encapsulation (700).

19. Procédé selon l'une des revendications 1 à 18, dans lequel l'au moins une région (200) comprend au moins une connexion électrique ou une région sensible capteur MEMS.

## Patentansprüche

1. Verfahren zur Exposition wenigstens einer Region (200) einer Fläche, genannt Vorderfläche (110), einer elektronischen Vorrichtung (100), wobei das Verfahren die folgenden Schritte umfasst:
a) einen Schritt des Klebens wenigstens einer Kappe (600) auf die Vorderfläche (110), wobei das Kleben derart durchgeführt wird, dass die Kappe (600) zusammen mit der Region (200) einen geschlossenen, vorzugweise hermetisch geschlossenen Hohlraum (650) bildet;
b) das Bilden einer Einkapselungsschicht (700) mit einer Dicke E1 als Abdeckung der Vorderfläche (110) und der wenigstens einen Kappe (600);
c) einen Schritt des Abdünnens der Einkapselungsschicht (700), wobei der Schritt des Abdünnens das Entfernen einer Entfernungsdicke E2 kleiner als die Dicke E1 der Einkapselungsschicht (700) umfasst, wobei die Entfernungsdicke E2 dazu ausgelegt ist, dass eine Öffnung in der Kappe (600) gebildet wird.

2. Verfahren nach Anspruch 1, bei dem die Kappe (600) einen Boden (610) und eine Seitenwand (620) umfasst, wobei der Schritt des Klebens b) ausgeführt wird, indem man einen Rand der Seitenwand (620) in Kontakt mit der Vorderfläche (110) bringt.

3. Verfahren nach Anspruch 2, bei dem der Boden (610) der Kappe (600) mit einer Stoppschicht (630) bedeckt ist, wobei der Schritt des Abdünnens ferner derart selektiv ist, dass die Kappe (600) selektiv mit Bezug zu der Stoppschicht (630) geätzt wird.

4. Verfahren nach Anspruch 3, bei dem auf den Schritt c) ein Schritt d) des Entfernens der Stoppschicht (630) folgt, wobei der Schritt d) vorzugweise ein Schritt des chemischen Ätzens oder eines Trockenätzens ist.

5. Verfahren nach einem der Ansprüche 1 bis 4, bei dem der Schritt a) gemäß einem der Verfahren ausgeführt wird, ausgewählt aus: Kleben mittels eines Klebers, vorzugsweise eines Polymerklebers, Kleben durch Schweißen oder Löten vorzugsweise mit einem Material auf Basis von Zinn, von Silber und von Kupfer, Kleben mittels Sinteriung.

6. Verfahren nach einem der Ansprüche 1 bis 5, bei dem der Schritt des Abdünnens c) durch mechanische Erosion durchgeführt wird.

7. Verfahren nach einem der Ansprüche 1 bis 6, bei dem der Schritt b) durch Laminieren einer Lage von Einkapselungsmaterial durchgeführt wird, oder durch Injizieren eines Harzes, das aus Einkapselungsmaterial hergestellt ist.

8. Verfahren nach einem der Ansprüche 1 bis 7, bei dem die wenigstens eine Region (200) eine optische Kopplungsregion (204) umfasst, und eine erste Kappe (601) aus der wenigstens einen Kappe (200) dazu konfiguriert ist, eine Struktur zur Kopplung und zur Ausrichtung wenigstens einer optischen Faser (800) im Bereich der optischen Kopplungsregion zu bilden.

9. Verfahren nach Anspruch 8, bei dem dem Schritt a) die Bildung oder die Übertragung einer Strahlformungsoptik (260) auf der optischen Kopplungszone (204) vorhergeht.

10. Verfahren nach Anspruch 8 oder 9, bei dem die wenigstens eine optische Faser (800) im Bereich eines ihrer Enden in einer Druckhülse (500) gehalten wird, wobei die eine Druckhülse (500) einen optischen Ausgang (510) umfasst, der entlang einer Fläche, genannt Kopplungsfläche (520) der Druckhülse angeordnet ist, wobei der optische Ausgang (510) gegenüber der optischen Kopplungszone (204) ist, sobald die Ausrichtung zwischen der Druckhülse und einem optischen Kopplungselement (200a), das im Bereich der Kopplungszone (204) angeordnet ist, wirksam ist.

11. Verfahren nach Anspruch 10, bei dem die Druckhülse einen Kanal (530) umfasst, in dessen Inneren die wenigstens eine optische Faser (800) eingesetzt ist, wobei der Kanal (530) mit einem schrägen Spiegel (540) versehen ist, der dazu ausgelegt ist, eine Strahlung, die durch die wenigstens eine optische Faser (800) geleitet werden soll, in Richtung des optischen Ausgangs (510) abzulenken.

12. Verfahren nach Anspruch 10 oder 11, bei dem die Wand der ersten Kappe (601), genannt erste Wand (621), dazu ausgelegt ist, durch Einsetzen in ein erstes Innenvolumen (621a), das durch die erste Wand (621) definiert ist, ein Ausrichtungselement (521) in Projektion der Kopplungsfläche (520) aufzunehmen, das eine Umfangsoberfläche mit einer Form komplementär zur Form aufweist, die durch die erste Wand (621) definiert ist.

13. Verfahren nach einem der Ansprüche 10 bis 12, bei dem die wenigstens eine Kappe (600) ferner eine zweite Kappe (602) umfasst, deren Seitenwand (620), genannt zweite Wand (622), ein Innenvolumen bildet, genannt zweites Innenvolumen (622a), das dazu ausgelegt ist, durch Einsetzen eine Nase (523) aufzunehmen, die auf der Kopplungsfläche (520) angeordnet ist, und deren Umfangsoberfläche eine Form komplementär zu der Form aufweist, die durch die zweite Wand (622) definiert ist, wodurch ein Element der Kopplungs- und Ausrichtungsstruktur der wenigstens einen optischen Faser gebildet wird.

14. Verfahren nach Anspruch 13, bei dem die wenigstens eine Kappe (600) eine dritte Kappe umfasst, deren Seitenwand (620), genannt dritte Wand, ein Innenvolumen bildet, genannt drittes Innenvolumen, das dazu ausgelegt ist, durch Einsetzen eine zweite Nase aufzunehmen, die auf der Kopplungsfläche (520) angeordnet ist, und deren Umfangsoberfläche eine Form komplementär zu der Form aufweist, die durch die dritte Wand definiert ist, wodurch ein Element der Kopplungs- und Ausrichtungsstruktur der wenigstens einen optischen Faser gebildet wird.

15. Verfahren nach einem der Ansprüche 1 bis 14, bei dem die elektronische Vorrichtung (100) wenigstens eine elektronische Struktur (300) umfasst, die auf eine Hauptfläche (410) einer Tragstruktur (400) übertragen ist, wobei die im Schritt b) gebildete Einkapselungsschicht (700) eine Abdeckung der Hauptfläche (410) und der wenigstens einen elektronischen Struktur (300) ist, wobei vorzugsweise die wenigstens eine Region (200) eine erste Region (201) umfasst, die auf der Hauptfläche (410) der Tragstruktur (400) angeordnet ist.

16. Verfahren nach Anspruch 15, bei dem die wenigstens eine Region (200) eine zweite Region (202) umfasst, die auf der elektronischen Struktur (300) angeordnet ist.

17. Verfahren nach den Ansprüchen 1 bis 16, bei dem die wenigstens eine elektronische Struktur (300) eine Mehrzahl von elektronischen Strukturen (302, 303) mit verschiedenen Höhen umfasst, wobei vorzugsweise der Schritt a) das Übertragen einer Mehrzahl von Kappen (600) auf eine Mehrzahl von Regionen (202, 203) umfasst, die im Bereich der elektronischen Strukturen (302, 303) angeordnet sind, wobei die Tiefe der Kappen (600) derart angepasst ist, dass jede von ihnen im Wesentlichen gleichzeitig während des Schritts c) geöffnet wird.

18. Verfahren nach Anspruch 16 oder 17, bei dem am Ende des Schritts des Abdünnens die elektronischen Struktur (300) im Wesentlichen mit der freien Oberfläche der Einkapselungsschicht (700) fluchtet.

19. Verfahren nach einem der Ansprüche 1 bis 18, bei dem die wenigstens eine Region (200) wenigstens einen elektrischen Anschluss oder eine empfindliche MEMS-Sensorregion umfasst.

## Claims

1. An exposure process for at least one region (200) of a face, known as the front face (110), an electronic device (100), the process including the following stages:
a) A bonding stage for at least one cover (600) on the front face (110), the bonding being undertaken such that the cover (600) forms a closed cavity (650) with the region (200), advantageously hermetically sealed;
b) Formation of an encapsulation coating (700), of thickness E1, covering the front face (110) and the at least one cover (600);
c) A thinning stage for the encapsulation coating (700), the thinning stage including removal of a removal thickness E2, which is less than thickness E1, of the encapsulation coating (700), the removal thickness E2 being adapted such that an opening is formed in the cover (600).

2. A process in accordance with claim 1, in which the cover (600) includes a base (610) and a side wall (620), the bonding stage b) being achieved by mating an edge of the side wall (620) with the front face (110).

3. A process in accordance with claim 2, in which the base (610) of the cover (600) is covered by a barrier layer (630), the thinning stage additionally being selective to ensure selective engraving of the cover (600) relative to the barrier layer (630).

4. A process in accordance with claim 3, in which stage c) is followed by a stage d) for removal of the barrier layer (630), advantageously stage d) is a chemical or dry engraving stage.

5. A process in accordance with claims 1 to 4, in which stage a) is achieved in accordance with one of the methods chosen among : bonding with adhesive, advantageously a polymer adhesive, bonding by welding or soldering advantageously using a tin, copper and silver-based fusible material, bonding by sintering.

6. A process in accordance with claims 1 to 5, in which the thinning stage c) is achieved by mechanical erosion.

7. A process in accordance with claims 1 to 6, in which stage b) is achieved by rolling a sheet of encapsulation material, or by injection of a resin consisting of encapsulation material.

8. A process in accordance with claims 1 to 7, in which the at least one region (200) includes an optical coupling region (204), and a first cover (601) among the at least one cover (200) configured to form a coupling and alignment structure of at least one optical fibre (800) in the optical coupling region.

9. A process in accordance with claim 8, in which stage a) is preceded by the formation or transfer of a beam shaping optical device (260) in the optical coupling zone (204).

10. A process in accordance with claims 8 or 9, in which the at least one optical fibre (800) is retained at one of its ends in a ferrule (500), the said ferrule (500) including an optical output (510) located on a face, known as the coupling face (520) of the ferrule, the optical output (510) facing the optical coupling zone (204) providing that the alignment between the ferrule and the optical coupling element (200a), located in the coupling zone (204), is effective.

11. A process in accordance with claim 10, in which the ferrule includes a passage (530) inside of which the at least one optical fibre (800) is inserted, the passage (530) featuring an oblique mirror (540) intended to deviate a radiation, susceptible to be guided by the at least one optical fibre (800), towards the optical output (510).

12. A process in accordance with claims 10 or 11, in which the wall of the first cover (601), known as the first wall (621), is arranged to accommodate, by insertion in a first internal cavity (621a) defined by the said first wall (621), an alignment element (521) in projection of the coupling face (520) and featuring a peripheral surface whose shape is complementary to the shape defined for the first wall (621).

13. A process in accordance with claims 10 to 12, in which the at least one cover (600) additionally includes a second cover (602), whose side wall (620), known as the second wall (622), forms an internal cavity, known as the second internal cavity (622a), intended to accommodate, by insertion, a lug (523) located on the coupling face (520) and whose peripheral surface is of shape complementary to the shape defined by the second wall (622), forming an element of the coupling and alignment structure of the at least one optical fibre.

14. A process in accordance with claim 13, in which the at least one cover (600) includes a third cover, whose side wall (620), known as the third wall, forms an internal cavity, known as the third internal cavity, intended to accommodate, by insertion, a second lug located on the coupling face (520) and whose peripheral surface is of a shape complementary to the shape defined by the third wall, forming an element of the coupling and alignment structure of the at least one optical fibre.

15. A process in accordance with claims 1 to 14, in which the electronic device (100) includes at least one electronic structure (300) transferred to a main face (410) of a support structure (400), the encapsulation coating (700) formed at stage b) covering the main face (410) and the at least one electronic structure (300), advantageously the at least one region (200) includes a first region (201) located on the main face (410) of the support structure (400).

16. A process in accordance with claim 15, in which the at least one region (200) includes a second region (202) located on the electronic structure (300).

17. A process in accordance with claims 1 to 16, in which the at least one electronic structure (300) includes a number of electronic structures (302, 303) of different heights, advantageously, stage a) includes the transfer of a number of covers (600) on a number of regions (202, 203) located on the electronic structures (302, 303), the depth of the covers (600) being adjusted such that they are all opened, essentially, simultaneously during stage c).

18. A process in accordance with claims 16 or 17, in which on completion of the thinning stage the electronic structure (300) is essentially flush with the free surface of the encapsulation coating (700).

19. A process in accordance with claims 1 to 18, in which the at least one region (200) includes at least one electrical connection or an MEMS sensor sensitive region.
